# EUROPÄISCHE PATENTSCHRIFT

(11) **EP 1 162 663 B1**
(45) Veröffentlichungstag und Bekanntmachung des Hinweises auf die Patenterteilung: **14.08.2013**
(21) Anmeldenummer: 01112934.3
(22) Anmeldetag: 06.06.2001
(51) Int. Cl.: H01L 27/108, H01L 21/8242, H01L 27/12

(54) **Herstellungsverfahren für eine DRAM-Speicherzelle**
Method of forming DRAM memory cell
Procédé de fabrication d'une cellule de mémoire DRAM

(30) Priorität: 06.06.2000 DE 10028424
(43) Veröffentlichungstag der Anmeldung: 12.12.2001
(73) Patentinhaber: Qimonda AG, 81739 München (DE)
(72) Erfinder: Hofmann, Franz, Dr., 80995 München (DE); Schloesser, Till, Dr., 01109 Dresden (DE)
(74) Vertreter: Isarpatent

(56) Entgegenhaltungen:
- EP-A2- 0 940 853
- EP-A2- 0 948 053
- DE-C1- 19 911 148
- JP-A- 5 029 573
- JP-A- 7 321 332
- US-A- 5 959 322

## Beschreibung

Die Erfindung betrifft ein Verfahren zur Herstellung einer DRAM-Speicherzelle für eine DRAM-Speichervorrichtung, wobei die DRAM-Speicherzelle eine hohe Auslese- und Abspeichergeschwindigkeit besitzt.

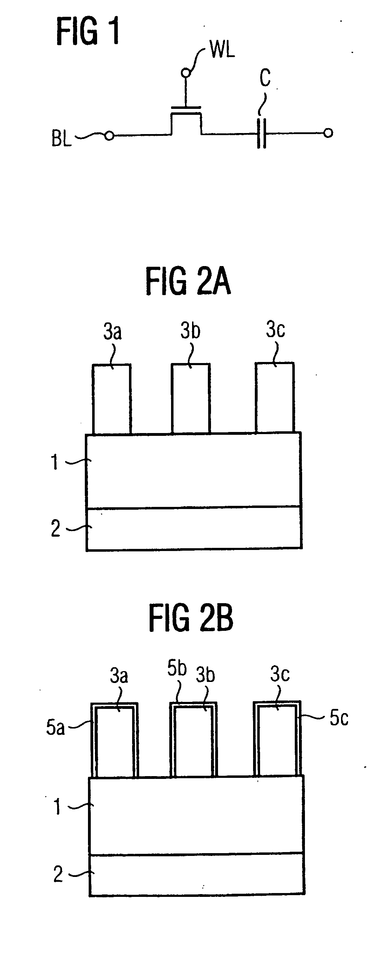

Ein DRAM-Speicher ist ein dynamischer Halbleiterspeicher, der als Speicherzelle in der Speichermatrix eine Speicherkapazität enthält, die über einen Auswahltransistor an eine Bitleitung angeschlossen werden kann. Wird eine Wortleitung WL auf einen hohen Spannungspegel gelegt, so öffnet sich der Auswahltransistor, und die Speicherkapazität wird an die Bitleitung BL geschaltet. In diesem Zustand kann die Speicherzelle beschrieben werden, indem die Kapazität entsprechend dem gewünschten Speicherinhalt entladen oder geladen wird. Fig. 1 zeigt den Aufbau einer typischen DRAM-Speicherzelle nach dem Stand der Technik.

Um einen höheren Integrationsgrad von Speicherzellen auf einem Halbleitersubstrat zu erreichen, werden zunehmend Strukturen mit vertikal angeordneten Auswahltransistoren vorgeschlagen.

Die US 5,612,559 beschreibt eine Halbleitervorrichtung mit einer Vielzahl von Speicherzellen. Jede Speicherzelle weist dabei einen säulenförmigen, vertikal angeordneten Auswahltransistor auf, der einen Drainbereich und einen Sourcebereich in einer Halbleiter-Substratsäule enthält, wobei zwischen dem Drain- und dem Sourcebereich ein ebenfalls in Vertikalrichtung verlaufender Stromkanal verläuft, der durch eine Steuergate-Elektrode gesteuert wird, die die Halbleiter-Substratsäule getrennt durch eine Oxidschicht vollständig umschließt. Die dabei ausgebildete Steuergate-Elektrode wird durch Rückätzen einer leitenden Schicht, die beispielsweise aus dotiertem Polysilizium besteht, gebildet. Die Steuergate-Elektroden verschiedener Speicherzellen sind elektrisch miteinander verbunden und bilden die Wortleitung zur Ansteuerung des Auswahltransistors.

Die in der US 5,612,559 beschriebene Speicherzelle weist den Nachteil auf, dass die Lese- und Speichergeschwindigkeit eines DRAM-Speichers, der aus derartigen Speicherzellen aufgebaut wird, sehr niedrig ist. Die aus dem abgeschiedenen Polysilizium gebildete Wortleitung der in der US 5,612,559 beschriebenen Speichervorrichtung weist einen hohen elektrischen Widerstand aufgrund der Materialeigenschaft von Polysilizium auf. Darüber hinaus ist der Querschnitt der aus Polysilizium gebildeten Wortleitung im Bereich der umschlossenen Halbleiter-Substratsäulen sehr gering. Der geringe Querschnitt der Wortleitung hat ebenfalls eine Erhöhung des elektrischen Widerstandes der Wortleitung zur Folge. Da bei einem typischen DRAM-Speicher mindestens 500 Speicherzellen über eine Wortleitung miteinander verbunden sind, ergibt sich durch die serielle Verbindung der Speicherzellen über die hochohmige Wortleitung insgesamt ein sehr hoher Widerstand. Durch den hohen Widerstand der Wortleitung kommt es zu hohen RC-Laufzeiten und somit niedrigen Lese- und Speichergeschwindigkeiten bei einem derartig aufgebauten DRAM-Speicher.

Ein weiterer Nachteil der in der US 5,612,559 beschriebenen Struktur besteht darin, dass der Auswahltransistor über Kontaktlöcher mit der Bitleitung verbunden ist. Die Herstellung derartiger Kontaktlöcher ist im Herstellungsverfahren relativ aufwendig und führt bei kleinen Strukturgrößen häufig zu Fehlkontaktierungen, die zu einem Ausfall von Speicherzellen oder sogar zu einem Ausfall des gesamten DRAM-Speichers führen.

Die JP 7 321332 A offenbart ein Herstellungsverfahren für eine DRAM-Speicherzelle, bei dem auf einem Halbleiterwafer eine Polysilizium-Bitleitung ausgebildet und mit einer isolierenden Zwischenschicht sowie einer darüberliegenden Polysiliziumschicht abgedeckt wird. Auf die Polysiliziumschicht wird nach einer Planarisierung ein Stützsubstrat aufgebracht.

An der Gegenseite wird der Halbleiterwafer so abgeschliffen und strukturiert, dass auf der Bitleitung ein freiliegender Halbleiterstreifen verbleibt. Auf dem Halbleiterstreifen wird eine Gateoxidschicht gebildet, und darüber Polysilizium abgeschieden. Durch reaktives Ionenätzen werden Seitenwand-Gateelektroden ausgebildet. Durch eine darüber gebildete weitere isolierende Zwischenschicht wird ein bis zum Halbleiterstreifen reichendes Kontaktloch geöffnet, durch das Dotierungsionen zur Bildung eines Sourcebereichs eingebracht werden. Nach Verfüllen des Kontaktlochs mit einem leitfähigen Material werden über diesem ein Ladungsknoten, eine dielektrische Kondensatorschicht und eine Gegenelektrode gebildet.

Es ist die Aufgabe der vorliegenden Erfindung, ein Verfahren zur Herstellung einer DRAM-Speicherzelle für eine DRAM-Speichervorrichtung zu schaffen, das einen hohen Integrationsgrad bei gleichzeitig einfachem Herstellungsprozess bietet und die eine hohe Lese- und Schreibgeschwindigkeit der DRAM-Speichervorrichtung gewährleistet.

Diese Aufgabe wird erfindungsgemäß durch ein Verfahren zur Herstellung einer DRAM-Speicherzelle mit den im Patentanspruch 1 angegebenen Merkmalen gelöst.

Eine beispielhafte DRAM-Speicherzelle für eine DRAM-Speichervorrichtung umfasst:
einen MOSFET-Auswahltransistor, der einen Drainbereich und einen Sourcebereich in einer Halbleiter-Substratsäule aufweist,
wobei zwischen dem Drain- und dem Sourcebereich ein in Vertikalrichtung verlaufender Stromkanal vorgesehen ist, der durch eine Steuergate-Elektrode steuerbar ist,
einen unter dem MOSFET-Auswahltransistor gestapelten Kondensator, der mit dem Sourcebereich in der Halbleiter-Substratsäule elektrisch verbunden ist, und
eine über dem MOSFET-Auswahltransistor gelegene Metall-Bitleitung BL, die mit dem Drainbereich in der Halbleiter-Substratsäule elektrisch verbunden ist,
wobei eine Metall-Wortleitung WL vorgesehen ist, die die Steuergate-Elektrode des MOSFET-Auswahltransistors direkt elektrisch kontaktiert und zu der Metall-Bitleitung, die den Drainbereich selbstjustierend, elektrisch kontaktiert senkrecht verläuft.

Beispielsweise weist die Metall-Wortleitung einen Querschnitt auf, der der minimalen lithographischen Strukturgröße F entspricht.

Die Steuergate-Elektrode besteht vorzugsweise aus abgeschiedenem Polysilizium.

Beispielsweise verläuft die Steuergate-Elektrode im Wesentlichen parallel zu dem in der Halbleiter-Substratsäule befindlichen Stromkanal.

Zwischen der Steuergate-Elektrode und dem Stromkanal liegt vorzugsweise eine dielektrische Schicht mit einer Dicke von 4 bis 7 nm.

Die Metall-Bitleitung besteht vorzugsweise aus einer strukturierten mehrlagigen Schicht, die eine Titannitridschicht, eine Wolframschicht und eine Polysiliziumschicht aufweist.

Der Kondensator ist vorzugsweise elektrisch an eine Gegenelektrode angeschlossen.

Die Metall-Bitleitung und die Gegenelektrode kontaktieren dabei die DRAM-Speicherzelle vorzugsweise von zwei einander gegenüberliegenden Seiten.

Bei einer beispielhaften DRAM-Speicherzelle ist der Kondensator mit dem Sourcebereich über vertikal verlaufende Polysiliziumsäulen elektrisch verbunden.

Die Polysiliziumsäulen sind vorzugsweise von der Metall-Wortleitung durch eine vertikal verlaufende erste Isolierschicht elektrisch isoliert.

Beispielsweise ist die Metall-Wortleitung durch eine zweite Isolierschicht von der Gegenelektrode elektrisch isoliert.

Vorzugsweise ist die Bitleitung der Steuergate-Elektrode über eine dritte Isolierschicht elektrisch isoliert.

Bei einer beispielhaften DRAM-Speicherzelle bestehen die Isolierschichten aus Siliziumnitrid.

Bei einer weiteren beispielhaften DRAM-Speicherzelle weist der Kondensator eine dielektrische Schicht aus Tantalpentoxid auf.

Die Erfindung schafft ein Verfahren zur Herstellung von DRAM-Speicherzellen für eine DRAM-Speichervorrichtung mit den folgenden Schritten:
Ausbilden von Halbleiter-Substratsäulen auf einer Hauptträger-Oxidschicht, die über einem Hauptträger-Halbleitersubstrat liegt,
Implantieren von Dotierungsionen zur Erzeugung eines Drain- und eines Sourcebereichs in den Halbleiter-Substratsäulen, thermisches Oxidieren der Halbleiter-Substratsäulen zur Erzeugung einer dielektrischen Gateoxidschicht,
Abscheiden einer Polysiliziumschicht, einer Metallschicht und einer Isolationsschicht auf der oxidierten Halbleiter-Substratsäule,
anisotropes, chemisch-selektives Trockenätzen der abgeschiedenen Schichten zur Erzeugung von Steuergate-Elektroden und von Metall-Wortleitungen,
Ausbilden von Polysiliziumsäulen zur elektrischen Kontaktierung der Sourcebereiche in den Halbleiter-Substratsäulen, Abscheiden einer dielektrischen Kondensatorschicht auf den ausgebildeten Polysiliziumsäulen,
Aufbringen einer Gegenelektrode auf der dielektrischen Kondensatorschicht,
Anbringen eines Hilfsträgersubstrats auf der Seite der Gegenelektrode,
Entfernen des Hauptträgersubstrats und der Hauptträger-Oxidschicht, und
Ausbilden einer strukturierten Metall-Bitleitung zur direkten elektrischen Kontaktierung der Drainbereiche in den Halbleiter-Substratsäulen.

Im Weiteren werden bevorzugte Ausführungsformen des erfindungsgemäßen Herstellungsverfahrens unter Bezugnahme auf die beigefügten Figuren beschrieben.

Es zeigen:
Fig. 1 ein Schaltkreisdiagramm einer typischen DRAM-Speicherzelle;
Fig. 2a-2e Schnittansichten zur Darstellung verschiedener Prozessschritte bei der Herstellung einer DRAM-Speicherzelle gemäß einer Ausführungsform;
Fig. 3a - 3d Draufsichten auf erfindungsgemäß hergestellte DRAM-Speicherzellen bei verschiedenen Prozessschritten des erfindungsgemäßen Herstellungsverfahrens.

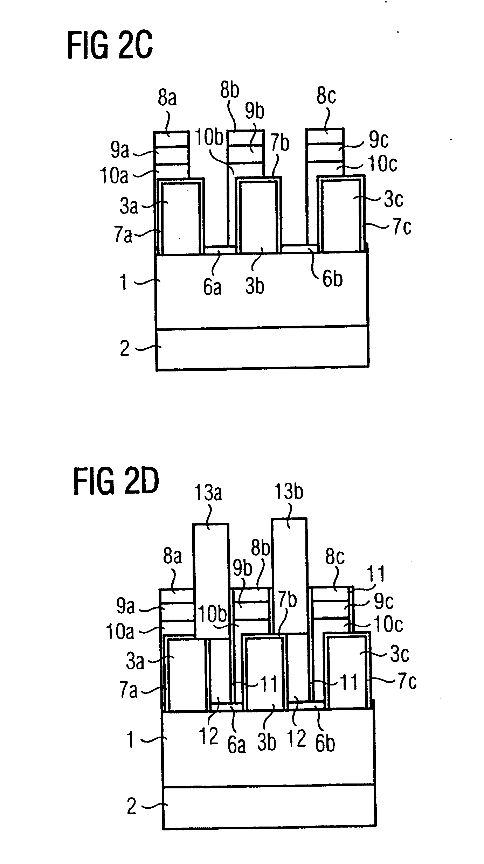

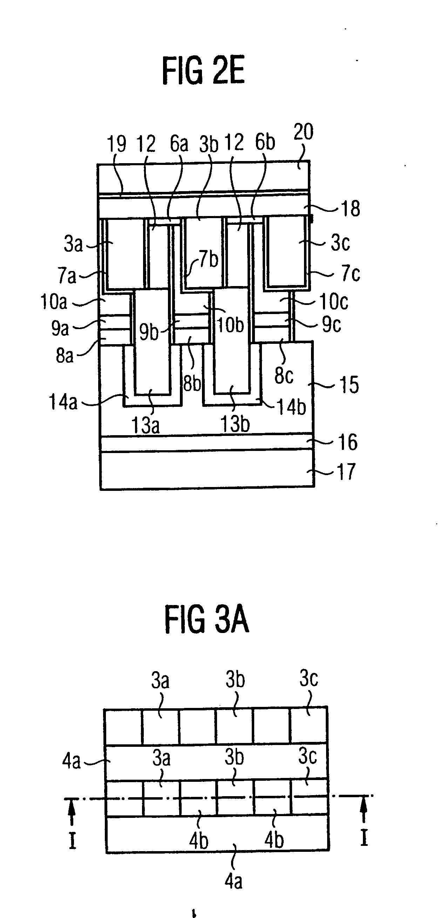

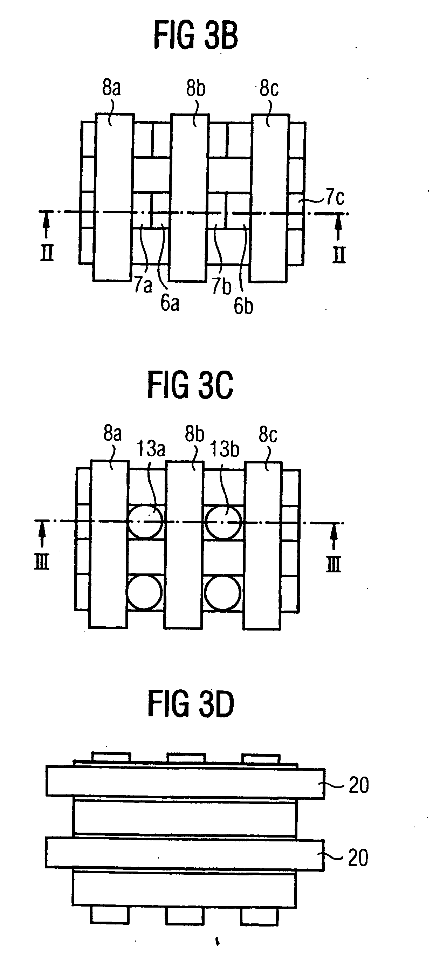

Im Weiteren werden die einzelnen Prozessschritte zur Herstellung der DRAM-Speicherzelle unter Bezugnahme auf die Fig. 2, 3 beschrieben.

Auf einem SOI-Wafer wird, wie in Fig. 2a erkennbar, zunächst eine Vielzahl von Halbleiter-Substratsäulen aufgebracht. Der SOI-Wafer weist eine Hauptträger-Oxidschicht 1 und eine Hauptträger-Substratschicht 2 auf. Die Hauptträger-Oxidschicht 1 besteht beispielsweise aus Siliziumdioxid und besitzt eine Dicke zwischen 0,5 und 2 µm. Die Hauptträger-Substratschicht 2 des SOI-Wafers besteht aus Bulk-Silizium und weist beispielsweise eine Dicke von etwa 0,4 mm auf. Über der Hauptträger-Oxidschicht 1 befindet sich eine Halbleiter-Substratschicht 3, die zunächst p-dotiert wird. Anschließend wird die Halbleiter-Substratschicht 3 maskiert und zu Halbleiter-Substratstreifen geätzt, die in Richtung der später ausgebildeten Bitleitungen 20 verlaufen. Die bei dem Ätzvorgang ausgebildeten Ätzgräben werden anschließend mit einem Isolationsmaterial 4a, beispielsweise Siliziumdioxid, aufgefüllt. Nach einer weiteren Maskierung erfolgt eine anisotrope Trockenätzung, bei der in die freiliegenden, horizontal verlaufenden Halbleiter-Substratstreifen gleichmäßig beabstandete Ausnehmungen geätzt werden, die ihrerseits mit Siliziumdioxid 4b aufgefüllt werden. Auf diese Weise entstehende gleichmäßig beabstandete Halbleiter-Substratsäulen 3a, 3b, 3c, die durch das aufgefüllte Isolationsmaterial 4b voneinander getrennt sind, sind in Fig. 3a erkennbar.

Fig. 2a zeigt die Struktur nach den oben genannten Prozessschritten zur Ausbildung der auf dem SOI-Wafer aufgebrachten Halbleiter-Substratsäulen 3a, 3b, 3c, wobei die Fig. 2a eine Schnittansicht entlang der Linie I-I der in Fig. 3a dargestellten Draufsicht auf die Speicherzelle ist.

Nach der Ausbildung der Halbleiter-Substratsäulen 3a, 3b, 3c werden diese zur Ausbildung einer strukturierten Opferoxidschicht (SAC-OX: Sacrificial Oxide) 5a, 5b, 5c bei 800-1000 °C thermisch oxidiert. Fig. 2b zeigt die resultierende Struktur.

In einem weiteren Prozessschritt wird eine Siliziumnitridschicht in einem CVD-Prozess abgeschieden und eine chemisch-mechanische Planarisierung CMP durchgeführt. Zur Ausbildung eines Drainbereichs werden anschließend Ionen in den oberen Bereich der Halbleiter-Substratsäulen 3a, 3b, 3c implantiert. Zur n⁺-Implantation können beispielsweise Arsenionen verwendet werden. Das nach dem chemisch-mechanischen Planarisierungsschritt CMP zwischen den Halbleiter-Substratsäulen 3a, 3b, 3c verbliebene abgeschiedene Siliziumnitrid wird in einem nächsten Schritt rückgeätzt, bis an den Grabenböden relativ dünne Siliziumnitridschichten 6a, 6b verbleiben. Die Opferoxidschicht 5a, 5b, 5c wird mit Flusssäure abgeätzt und die dadurch freiliegenden Halbleiter-Substratsäulen 3a, 3b, 3c thermisch zur Erzeugung einer strukturierten dielektrischen Gateoxidschicht 7a, 7b, 7c oxidiert. Die strukturierte Gateoxidschicht 7a, 7b, 7c weist vorzugsweise eine Dicke von 4-7 nm auf. Anschließend wird die Gesamtstruktur mit einer Polysiliziumschicht überzogen, auf die eine Metallschicht aufgebracht wird. Auf die aufgebrachte Metallschicht wird ihrerseits eine Siliziumnitridschicht abgelagert. Die Metallschicht besteht beispielsweise aus Wolfram oder aus Wolframsilizid.

Nach streifenförmiger Maskierung werden die aufgebrachten Schichten in einem Ätzvorgang anisotrop chemisch-selektiv geätzt, bis die in Fig. 2c dargestellte Struktur erreicht ist. Man erkennt in Fig. 2c untereinander liegende Streifen, nämlich Siliziumnitridstreifen 8a, 8b, 8c, Metallstreifen 9a, 9b, 9c sowie darunterliegende Polysiliziumstreifen 10a, 10b, 10c. Fig. 2c stellt eine Schnittansicht entlang der Linie II-II bei der in Fig. 3b gezeigten Speicherzelle dar. Bei der in Fig. 2c dargestellten Struktur ist der Auswahl-MOSFET der später fertigen DRAM-Zelle bereits fertig ausgebildet.

Auf die in Fig. 2c dargestellte Struktur wird in einem CVD-Prozess Siliziumnitrid zur Ausbildung von Spacern abgeschieden, das anschließend in einem anisotropen Trockenätzvorgang ausgesetzt wird. Es entstehen hierdurch die in Fig. 2d vertikal verlaufenden Siliziumnitrid-Spacer 11 zur elektrischen Isolierung der leitenden Streifen 8, 9, 10 voneinander. Die verbleibenden Ausnehmungen werden durch ein Oxid 12 aufgefüllt und die gesamte Struktur anschließend planarisiert.

In einem weiteren Prozessschritt werden die Kontaktlöcher für die späteren Kondensatoren durch anisotropes Rückätzen gebildet und diese Kontaktlöcher mit Polysilizium aufgefüllt. Nach chemisch-mechanischer Planarisierung CMP und einem weiteren Rückätzschritt eines Fülloxids entstehen die in Fig. 2d dargestellten Polysiliziumsäulen 13a, 13b. Die Polysiliziumsäulen 13a, 13b sind dabei mit den Halbleiter-Substratsäulen 3a, 3b elektrisch verbunden. Fig. 2d stellt eine Schnittansicht entlang der Linie III-III der in Fig. 3c gezeigten Draufsicht auf die Speicherzellen dar.

Die Polysiliziumsäulen 13a, 13b werden mit einer dielektrischen Schicht 14a, 14b überzogen, die beispielsweise aus Tantalpentoxid oder Siliziumnitrid besteht. Auf der strukturierten dielektrischen Schicht 14a, 14b wird in einem weiteren Schritt eine Polysiliziumschicht abgeschieden. Die abgeschiedene Polysiliziumschicht wird zur Ausbildung einer Gegenelektrode für den Kondensator im Zellenfeld strukturiert. Die strukturierte Gegenelektrode wird in einem weiteren Schritt mit einem Fülloxid aufgefüllt, woraufhin eine chemisch-mechanische Planarisierung CMP erfolgt. An das planarisierte Fülloxid 16 wird in einem Wafer-Bondingschritt ein Hilfsträgersubstrat 17 angebracht bzw. aufgeklebt. Dies geschieht durch Aufheizen der gegenüberliegenden Flächen und anschließendes Zusammenfügen. Nach dem Zusammenfügen wird die Grenzfläche abgekühlt und für eine vorbestimmte Zeitdauer gewartet, bis eine unlösbare chemische Bindung zwischen dem planarisierten Oxid 16 und dem Hilfsträgersubstrat 17 entstanden ist.

Die Bearbeitung der entstandenen Struktur erfolgt für die weiteren Prozessschritte von der gegenüberliegenden Seite. Hierzu wird die gesamte Struktur "umgedreht" und die nunmehr oben liegende Hauptträger-Substratschicht 2 durch Nassätzen weggeätzt. Durch chemisch-mechanische Planarisierung CMP oder durch einen weiteren Ätzschritt wird ferner die Hauptträger-Oxidschicht 1 entfernt. In die nunmehr freiliegenden Oberflächen der Halbleiter-Substratsäulen 3a, 3b, 3c werden Ionen zur Ausbildung von Drainbereichen des Auswahl-MOSFETs implantiert. Anschließend wird die gesamte Struktur mit Polysilizium 18 überzogen. Darüber wird vorzugsweise eine Titannitridschicht 19 aufgebracht, die ihrerseits mit einer Metallschicht 20 aus Wolfram überzogen wird. Die Titannitrid-Zwischenschicht 19 dient der besseren Haftung der Metallschicht 20 auf dem Polysilizium 18. Die aufgebrachten Schichten 18, 19, 20 werden in einem weiteren Prozessschritt zur Ausbildung von Bitleitungen BL strukturiert.

Fig. 2e zeigt die fertige DRAM-Struktur nach Ausführung des erfindungsgemäßen Herstellungsverfahrens. Fig. 3d zeigt eine Draufsicht nach Ausführung der Herstellungsschritte zur Ausbildung der DRAM-Struktur.

Die Halbleiter-Substratsäulen 3a, 3b, 3c weisen jeweils einen vertikal verlaufenden Stromkanal auf, der getrennt durch das Gateoxid 7a, 7b, 7c durch Steuergate-Elektroden 10a, 10b, 10c elektrisch ansteuerbar ist. Bei der in Fig. 2e gezeigten Darstellung befindet sich der Drainbereich in den Halbleiter-Substratsäulen 3a, 3b, 3c jeweils oben und ist direkt mit der strukturierten Polysiliziumschicht 18 elektrisch verbunden. Der Sourcebereich des MOSFET-Auswahltransistors befindet sich bei der in Fig. 2e gezeigten Darstellung innerhalb der Halbleiter-Substratsäulen 3a, 3b, 3c jeweils unten und ist direkt elektrisch mit den Polysiliziumsäulen 13a, 13b verbunden. Die unter den MOSFET-Auswahltransistoren gelegenen gestapelten Kondensatoren werden durch die Gegenelektrode 15 und die davon durch eine dielektrische Schicht 14a, 14b getrennt liegenden Polysiliziumstreifen 13a, 13b gebildet.

Wie man aus Fig. 2e erkennen kann, sind die Steuergate-Elektrodenbereiche 10a, 10b, 10c des MOSFET-Auswahltransistors direkt elektrisch mit den Wortleitungsstreifen 9a, 9b, 9c verbunden. Die Metall-Wortleitungen 9a, 9b, 9c bestehen dabei vorzugsweise aus Wolfram oder aus Wolframsilizid. Die Metall-Wortleitungen weisen daher einen sehr niedrigen elektrischen Widerstand zur Ansteuerung der Steuergate-Elektroden 10a, 10b, 10c auf. Dabei entspricht der Querschnitt der Metall-Wortleitungen 9a, 9b, 9c etwa der minimalen lithographischen Strukturgröße F des Herstellungsprozesses und ist somit vergleichsweise groß. Dieser große Querschnitt senkt zusätzlich die Widerstandsleitfähigkeit der Metall-Wortleitungen 9a, 9b, 9c. Die Steuergate-Elektroden 10a, 10b, 10c verlaufen parallel zu dem jeweiligen, in der Halbleiter-Substratsäule 3a, 3b, 3c gelegenen stromleitenden Kanal des MOSFETs in vertikaler Richtung.

Die in der Schnittansicht in Fig. 2e dargestellten Wortleitungen 9a, 9b, 9c und die strukturierten Bitleitungen 20 verlaufen senkrecht zueinander. Wie man aus Fig. 2e weiter erkennen kann, sind die Bitleitungen 20 selbstjustierend direkt elektrisch mit den Drainbereichen der Halbleiter-Substratsäulen 3a, 3b, 3c verbunden, ohne dass hierfür Kontaktlöcher hergestellt werden müssen. Der Anschluss der Drainbereiche an die Bitleitungen 20 ist daher prozesstechnisch sehr einfach herstellbar. Die in Fig. 2e dargestellte DRAM-Speicherzelle bietet einen sehr hohen Integrationsgrad aufgrund der vertikal angeordneten Auswahl-MOSFETs und der darunter gestapelten Kondensatoren. Eine Speicherzelle weist in etwa die Größe von 4 F² auf, wobei die kleinste definierte lithographische Größe F ≤ 0,2 µm ist. Der Herstellungsprozess zur Herstellung der DRAM-Speicherzelle ist sehr einfach und weist insbesondere einen sehr einfachen Metallisierungsvorgang auf. Aufgrund der direkten Kontaktierung der Steuerelektrodenanschlüsse 10a, 10b, 10c der Auswahl-MOSFETs durch Metall-Wortleitungen 9a, 9b, 9c können die Steuerelektroden der Auswahl-MOSFETS über einen sehr geringen elektrischen Widerstand angesteuert werden. Hierdurch wird die RC-Laufzeit sehr gering, und die Auslese- und Schreibgeschwindigkeit zum Auslesen bzw. Beschreiben der DRAM-Speicherzelle sind infolgedessen sehr hoch.

### Bezugszeichenliste

- 1: Hauptträger-Oxidschicht
- 2: Hauptträger-Halbleitersubstrat
- 3a, 3b, 3c: Halbleiter-Substratsäulen
- 4a, 4b: Fülloxid
- 5a, 5b, 5c: Opferoxidschichten
- 6a, 6b,: Isolationsschichten
- 7a, 7b, 7c: dielektrische Gateoxidschichten
- 8a, 8b, 8c: Isolierschichten
- 9a, 9b, 9c: Metall-Wortleitungen
- 10a, 10b, 10c: Steuergate-Elektroden
- 11: Isolationsschicht
- 12: Fülloxid
- 13a, 13b: Polysiliziumsäulen
- 14a, 14b: dielektrische Kondensatorschichten
- 15: Gegenelektrode
- 16: Oxid
- 17: Hilfsträgersubstrat
- 18: strukturiertes Polysilizium
- 19: Zwischenschicht
- 20: strukturierte Bitleitung

## Patentansprüche

1. Verfahren zur Herstellung von DRAM-Speicherzellen für einen DRAM-Speicher mit den folgenden Schritten:
(a) Ausbilden von Halbleiter-Substratsäulen (3a, 3b, 3c) auf einer Hauptträger-Oxidschicht (1), die über einer Hauptträger-Halbleiter-Substratschicht (2) liegt;
(b) Implantieren von Dotierungsionen zur Erzeugung eines Sourcebereichs in den Halbleiter-Substratsäulen (3a, 3b, 3c);
(c) thermisches Oxidieren der Halbleiter-Substratsäulen (3a, 3b, 3c) zur Erzeugung dielektrischer Gateoxidschichten (7a, 7b, 7c);
(d) Abscheiden einer Polysiliziumschicht, einer Metallschicht und einer Isolationsschicht auf den oxidierten Halbleiter-Substratsäulen (3a, 3b, 3c);
(e) anisotropes, chemisches, selektives Trockenätzen der abgeschiedenen Schichten zur Erzeugung von Steuergate-Elektroden (10a, 10b, 10c) und von Metall-Wortleitungen (9a, 9b, 9c);
(f) Ausbilden von Polysiliziumsäulen (13a, 13b) zur elektrischen Kontaktierung der Sourcebereiche in den Halbleiter-Substratsäulen (3a, 3b, 3c);
(g) Abscheiden einer dielektrischen Kondensatorschicht (14a, 14b) auf den ausgebildeten Polysiliziumsäulen (13a, 13b);
(h) Aufbringen einer Gegenelektrode (15) auf der dielektrischen Kondensatorschicht (14a, 14b);
(i) Anbringen eines Hilfsträger-Substrats (17) auf der Seite der Gegenelektrode (15);
(j) Entfernen der Hauptträger-Substratschicht (2) und der Hauptträger-Oxidschicht (1);
(k) Implantieren von Dotierungsionen in die Halbleiter-Substratsäulen (3a, 3b, 3c) zur Erzeugung von Drainbereichen;
(l) Ausbilden einer strukturierten Metall-Bitleitung (20) zur direkten elektrischen Kontaktierung der gebildeten Drainbereiche in den Halbleiter-Substratsäulen (3a, 3b, 3c).

## Claims

1. Method for manufacturing DRAM memory cells for a DRAM memory, comprising the following steps:
(a) forming semiconductor substrate columns (3a, 3b, 3c) on a primary carrier oxide layer (1) which is positioned above a primary carrier semiconductor substrate layer (2);
(b) implanting doping ions to produce a source region in the semiconductor substrate columns (3a, 3b, 3c);
(c) thermally oxidising the semiconductor substrate columns (3a, 3b, 3c) to produce dielectric gate oxide layers (7a, 7b, 7c);
(d) depositing a polysilicon layer, a metal layer and an insulation layer on the oxidised semiconductor substrate columns (3a, 3b, 3c);
(e) anisotropically, chemically and selectively dry-etching the deposited layers to produce control gate electrodes (10a, 10b, 10c) and metal word lines (9a, 9b, 9c);
(f) forming polysilicon columns (13a, 13b) for electrically contacting the source regions in the semiconductor substrate columns (3a, 3b, 3c);
(g) depositing a dielectric capacitor layer (14a, 14b) on the formed polysilicon columns (13a, 13b);
(h) placing a counter electrode (15) on the dielectric capacitor layer (14a, 14b);
(i) placing an auxiliary carrier substrate (17) on the side of the counter electrode (15);
(j) removing the primary carrier substrate layer (2) and the primary carrier oxide layer (1);
(k) implanting doping ions in the semiconductor substrate columns (3a, 3b, 3c) to produce drain regions;
(l) forming a structured metal bit line (20) for directly electrically contacting the formed drain regions in the semiconductor substrate columns (3a, 3b, 3c).

## Revendications

1. Procédé de fabrication de cellules de mémoire DRAM pour une mémoire DRAM comportant les étapes suivantes :
(a) formation de colonnes de substrat semi-conducteur (3a, 3b, 3c) sur une couche d'oxyde de support principal (1), qui repose sur une couche de substrat semi-conducteur de support principal (2) ;
(b) implantation d'ions de dopage pour générer une région de source dans les colonnes de substrat semi-conducteur (3a, 3b, 3c) ;
(c) oxydation thermique des colonnes de substrat semi-conducteur (3a, 3b, 3c) pour générer des couches d'oxyde de grille diélectriques (7a, 7b, 7c) ;
(d) dépôt d'une couche de polysilicium, d'une couche métallique et d'une couche isolante sur les colonnes de substrat semi-conducteur oxydées (3a, 3b, 3c) ;
(e) attaque à sec anisotrope, chimique, sélective des couches déposées pour générer des électrodes de grille de commande (10a, 10b, 10c) et des lignes de mots métalliques (9a, 9b, 9c) ;
(f) formation de colonnes de polysilicium (13a, 13b) pour la mise en contact électrique des régions de source dans les colonnes de substrat semi-conducteur (3a, 3b, 3c) ;
(g) dépôt d'une couche diélectrique de condensateur (14a, 14b) sur les colonnes de polysilicium (13a, 13b) formées ;
(h) application d'une contre-électrode (15) sur la couche diélectrique de condensateur (14a, 14b) ;
(i) apposition d'un substrat de support auxiliaire (17) du côté de la contre-électrode (15) ;
(j) retrait de la couche de substrat de support principal (2) et de couche d'oxyde de support principal (1) ;
(k) implantation d'ions de dopage dans les colonnes de substrat semi-conducteur (3a, 3b, 3c) pour générer des régions de drain ;
(l) formation d'une ligne de bits métallique structurée (20) pour la mise en contact directe des régions de drain formées dans les colonnes de substrat semi-conducteur (3a, 3b, 3c).
